(19) Europäisches Patentamt

European Patent Office

Office européen des brevets

(11) **EP 1 944 391 A1**

(12) **EUROPEAN PATENT APPLICATION**

(43) Date of publication:
**16.07.2008 Bulletin 2008/29**

(51) Int Cl.:
*C23C 30/00* (2006.01)     *C22C 29/08* (2006.01)
*B23B 27/14* (2006.01)

(21) Application number: **07121947.1**

(22) Date of filing: **30.11.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **27.12.2006 SE 0602812**

(71) Applicant: **Sandvik Intellectual Property AB 81181 Sandviken (SE)**

(72) Inventors:
• **LENANDER, Anders 135 53 Tyresö (SE)**

• **KJELLGREN, Jan 164 38 Kista (SE)**
• **ÅGREN, Torbjörn 791 46 Falun (SE)**
• **REINEBRANDT, Stefan 754 53 Uppsala (SE)**
• **ANDERSSON, Joakim 742 94 Östhammar (SE)**
• **GRANSTRÖM, Robert 757 57 Uppsala (SE)**

(74) Representative: **Hägglöf, Henrik Sandvik Intellectual Property AB 811 81 Sandviken (SE)**

(54) **CVD coated cemented carbide insert for toughness demanding short hole drilling operations**

(57) The present invention relates to a coated cutting insert with excellent toughness properties particularly useful for toughness demanding short hole drilling in general steel materials and a method of making the same. The inserts comprise a substrate and a coating. The substrate consists of WC, 8-11 wt-% Co and 0.2-0.5 wt-% Cr with an average WC-grain size of 0.5-1.5 $\mu$m and a CW-ratio of 0.80-0.90. The coating comprises

- a first (innermost) layer of $TiC_xN_yO_z$ with a thickness <1.5 $\mu$m,
- a layer of $TiC_xN_yO_z$ with a thickness of 1-8 $\mu$m with columnar grains,
- a layer of fine-grained grain $\kappa$-$Al_2O_3$ with a thickness of 0.5-5 $\mu$m and
- a further layer <1 $\mu$m thick of $TiC_xN_yO_z$ whereby at the rake face the outermost $TiC_xN_yO_z$-layer and $Al_2O_3$-layer are fully or partly missing.

Fig.1

**EP 1 944 391 A1**

**Description**

The present invention relates to a CVD coated cutting tool insert particularly useful for toughness demanding short hole drilling in general steel materials.

Drilling in metals is divided generally in two types: long hole drilling and short hole drilling. By short hole drilling is meant generally drilling to a depth of up to 3-5 times the drill diameter.

Long hole drilling puts large demands on good chip formation, lubrication, cooling and chip transport. This is achieved through specially developed drilling systems with specially designed drilling heads fastened to a drill rod and fulfilling the above mentioned demands.

In short hole drilling, the demands are lower, enabling the use of simple helix drills formed either of solid cemented carbide or as solid tool steel or of tool steel provided with a number of cutting inserts of cemented carbide placed in such a way that they together form the necessary cutting edge. In the centre of the head, a tough grade of insert is sometimes used and on the periphery a more wear resistant one. The cutting inserts are brazed or mechanically clamped.

The inserts are normally coated with a wear resistance coating. Two coating techniques are dominating: Physical Vapor Deposition (PVD) and Chemical Vapor Deposition (CVD).

WO 2006/080888 discloses PVD-coated cutting inserts with excellent toughness properties particularly useful for toughness demanding short hole drilling in low alloy and stainless steels. The inserts comprise a substrate and a coating. The substrate consists of WC with an average WC-grain size of 0.5-1.5 $\mu$m, 8-11 wt-% Co and 0.2-0.5 wt-% Cr with a coating of a laminar, multilayered structure of $TiN+Ti_{1-x}Al_xN$ in polycrystalline, non-repetitive form deposited by arc evaporation technique.

WO 2006/080889 discloses CVD-coated cutting inserts for short hole drilling in steel at high speed and moderate feed. The cemented carbide includes WC, 2-10 wt-% Co, and 4-12 wt-% cubic carbides of metals from groups IVa, Va or VIa. The Co-binder phase is highly alloyed with W with a CW-ratio of 0.75-0.90. The insert has a binder phase enriched and essentially cubic carbide free surface zone of a thickness of less than 20 $\mu$m. Along a line essentially bisecting the edge in the direction from the edge to the centre of the insert, a binder phase content increases essentially monotonously until it reaches the bulk composition. Binder phase content at the edge in vol-% is 0.65-0.75 times binder phase content of the bulk. The depth of the binder phase depletion is 100-300 $\mu$m.

EP-A-1655390 discloses CVD-coated inserts particularly useful for milling under wet conditions. The inserts are characterised by a WC-Co cemented carbide substrate with a low content of cubic carbides and a coating including an inner layer of $TIC_xN_y$ with columnar grains followed by a layer of $\kappa$-$Al_2O_3$ and a top layer of TiN.

PVD-coatings improve the wear resistance but also improve the toughness. CVD-coatings show superior wear resistance in comparison to PVD-coatings but inferior toughness properties. Consequently, CVD-coated inserts are most commonly used in operations with high demands regarding wear resistance and PVD-coated inserts in operations with high toughness demands.

The object of the present invention is to provide a CVD-coated cutting tool insert useful for toughness demanding short hole drilling in steel.

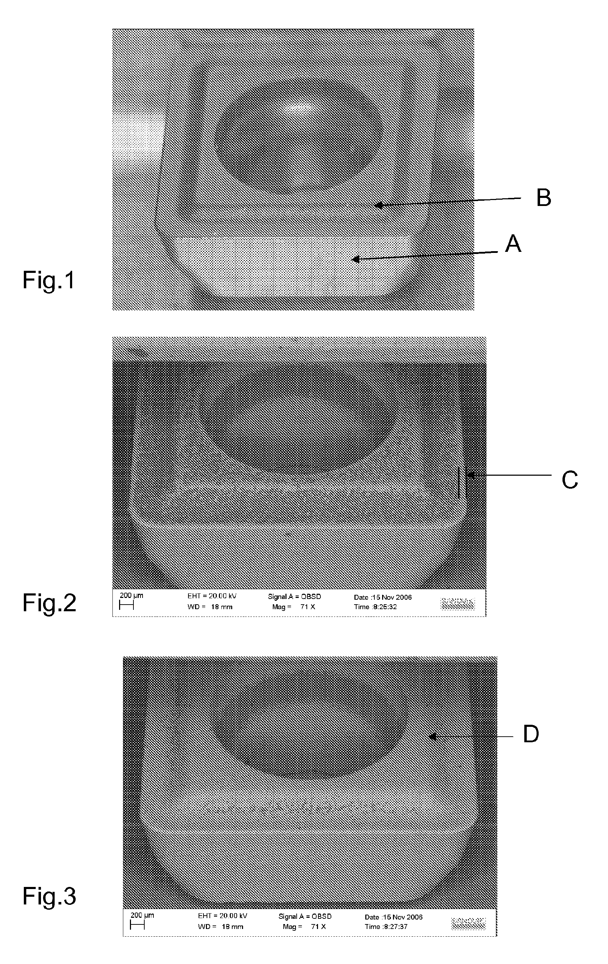

Fig. 1 is light microscope photo showing that the (golden) top layer is intact at the clearance face (A) while it is fully removed on the rake face (B).

Fig. 2 is an SEM back scattered electron micrograph showing that the second $TIC_xN_yO_z$ layer (light contrast) is exposed due to the removal of the alumina layer (dark contrast) at the area near the edge (C).

Fig. 3 is an SEM micrograph using back scattered electrons showing that the second $TIC_xN_yO_z$ layer is exposed at most of the rake face (D).

According to the invention, there is now provided cemented carbide inserts of a substrate and a coating with excellent toughness properties particularly useful for toughness demanding short hole drilling, in general of steels, the substrate comprising WC and 8-11 wt-% Co, preferably 9.5-10.5 wt-% Co and 0.2-0.5 wt-% Cr. The WC-grains have an average grain size of 0.5-1.5 $\mu$m.

The cobalt binder phase is rather highly alloyed with W. The content of W in the binder phase is expressed as the

$$\text{CW-ratio= magnetic-\% Co / wt-\% Co}$$

where magnetic-% Co is the weight percentage of magnetic Co and wt-% Co is the weight percentage of Co in the cemented carbide. The CW-value is a function of the W content in the Co binder phase. A CW-value of about 1 corresponds to a low W-content in the binder phase and a CW-value of about 0.75-0.8 correspond to a high W-content in the binder phase. The CW-ratio in inserts according to the present invention shall be 0.80-0.90.

The coating comprises:

- a first (innermost) layer of $TiC_xN_yO_z$ with x+y+z=1, preferably y>x and z<0.2, most preferably y>0.8 and z=0, with equiaxed grains with size <0.5 $\mu$m and a total thickness <1.5 $\mu$m, preferably >0.1 $\mu$m.
- a layer of $TiC_xN_yO_z$ with x+y+z=1, preferably with z=0, x>0.3 and y>0.3, most preferably x>0.5, with a thickness of 1-8 $\mu$m, preferably 2-7 $\mu$m, most preferably <6 $\mu$m, with columnar grains and with an average diameter of <5 $\mu$m, preferably 0.1-2 $\mu$m.
- a layer of a smooth, fine-grained, grain size about 0.5-2 $\mu$m, $Al_2O_3$ consisting essentially of the K-phase. However, the layer may contain small amounts, 1-3 vol-%, of the $\theta$- or the $\alpha$-phases as determined by XRD-measurement. The $Al_2O_3$-layer has a thickness of 0.5-5 $\mu$m, preferably 0.5-2 $\mu$m, and most preferably 0.5-1.5 $\mu$m. The $Al_2O_3$-layer is followed by a further layer, <1 $\mu$m, preferably 0.1-0.5 $\mu$m thick, of $TiC_xN_yO_z$ with x+y+z=1, preferably with y>x and z<0.3, most preferably y>0.8. The outermost $TiC_xN_yO_z$-layer and the $Al_2O_3$-layer are fully or partly removed on 80% of the rake face surface area between the edge line and 100 $\mu$m inwards, in the direction perpendicular to the edge line.

Furthermore, the second $TiC_xN_yO_z$ layer at the rake face should be in the compressive stress state of from 0 to 2500 MPa, preferably 500-1500 MPa.

The invention also relates to a method of making coated cemented carbide inserts with excellent toughness properties particularly useful for toughness demanding short hole drilling in general steels and stainless steels. The cemented carbide comprises WC and 8-11 wt-% Co, preferably 9.5-10.5 wt-% Co and 0.2-0.5 wt-% Cr. The WC-grains have an average grain size of 0.5-1.5 $\mu$m. The raw materials powders are wet milled to form a slurry with a pressing agent, small additions of carbon black or pure tungsten powder to obtain a CW-ratio in the sintered inserts of 0.80-0.90. After the wet milling, the slurry is dried to a powder, compacted and sintered. After conventional post sintering treatment a coating comprising:

- a first (innermost) layer of $TiC_xN_yO_z$ with x+y+z=1, preferably y>x and z<0.2, most preferably y>0.8 and z=0, with equiaxed grains with size <0.5 $\mu$m and a total thickness <1.5 $\mu$m, preferably >0.1 $\mu$m, using known CVD-methods.
- a layer of $TiC_xN_yO_z$ with x+y+z=1, preferably with z=0, x>0.3 and y>0.3, most preferably x>0.5, with a thickness of 1-8 $\mu$m, preferably 2-7 $\mu$m, most preferably <6 $\mu$m, with columnar grains and with an average diameter of about <5 $\mu$m, preferably 0.1-2 $\mu$m, using preferably MTCVD-technique using acetonitrile as the carbon and nitrogen source for forming the layer in the temperature range of 700-900 °C. The exact conditions, however, depend to a certain extent on the design of the equipment used.
- a smooth $Al_2O_3$-layer consisting essentially of $\kappa$-$Al_2O_3$ is deposited under known conditions, such as disclosed in, e.g., EP-A-523 021, hereby incorporated by reference in its entirety. The $Al_2O_3$ layer has a thickness of 0.5-5 $\mu$m, preferably 0.5-2 $\mu$m, and most preferably 0.5-1.5 $\mu$m. A further layer <1 $\mu$m, preferably 0.1-0.5 $\mu$m thick of $TiC_xN_yO_z$ is deposited, using known CVD-methods. The full or partial removal of the rake face top $TiC_xN_yO_z$ layer and the $Al_2O_3$-layer can be obtained by wet blasting of the coated surface with fine grained (400-150 mesh) alumina powder.

Example 1

Inserts made of cemented carbide with composition WC + 10 wt-% Co, 0.39 wt% Cr and average WC grain size of 1.0 $\mu$m and a CW-ratio of 0.86 were coated with a 0.5 $\mu$m equiaxed $TiC_{0.05}N_{0.95}$-layer (with a high nitrogen content corresponding to an estimated C/N-ratio of 0.05) followed by a 4 $\mu$m thick $TiC_{0.54}N_{0.46}$-layer, with columnar grains using MTCVD-technique, temperature 885-850 °C and $CH_3CN$ as the carbon/nitrogen source. In subsequent steps during the same coating cycle, a 1.0 $\mu$m thick layer of $Al_2O_3$ was deposited using a temperature of 970 °C and a concentration of $H_2S$ dopant of 0.4 % as disclosed in EP-A-523 021. A 0.3 $\mu$m layer of TiN was deposited on top according to known CVD-technique. XRD-measurement showed that the $Al_2O_3$-layer consisted of 100 % K-phase.

Example 2

Inserts from example 1 were treated by wet blasting with a blasting pressure of 2.2 bar. As a result of the blasting treatment all the top TiN-layer and parts of the $Al_2O_3$-layer at the rake face was removed. At the rake face area at the edge line and 100 $\mu$m inwards, in the direction perpendicular to the edge line, most of the alumina was gone and as a result the second $TiC_{0.54}N_{0.46}$-layer was exposed at >80% of this surface area. At the clearance face most of the top TiN layer was still intact.

The stress state in the second $TiC_{0.54}N_{0.46}$-layer was measured using X-ray diffraction. At the rake face the coating has compressive stress, -800 to -940 MPa. At the clearance face the stress state was tensile, +900 MPa.

The method for evaluating the stress state of the second $TiC_{0.54}N_{0.46}$-layer in this and the following examples was according the well known $\sin^2\psi$ method as described by I.C. Noyan, J.B. Cohen, Residual Stress Measurement by Diffraction and Interpretation, Springer-Verlag, New York, 1987 (pp 117-130). The stress evaluation was carried out by

## EP 1 944 391 A1

using ψ-geometry on a X-ray diffractometer Bruker D8 Discover-GADDS equipped with laser-video positioning, Euler 1/4-cradle, rotating anode as X-ray source ($CuK_\alpha$-radiation) and an area detector (Hi-star). A collimator of size 0.5 mm was used to focus the beam. The analysis was performed on the $TiC_xN_y$ (422) reflection using the goniometer settings $2\theta=126°$, $\omega=63°$ and $\Phi=0°, 90°, 180°, 270°$. Eight ψ tilts between 0° and 70° were performed for each Φ-angle. The $\sin^2\psi$ method was used to evaluate the residual stress using the software DIFFRAC$^{Plus}$ Stress32 v. 1.04 from Bruker AXS with the constants Young's modulus, E=480 GPa and Poisson's ratio, V=0.20 and locating the reflection using the Pseudo-Voigt-Fit function. A biaxial stress state was confirmed and the average value was used as the residual stress value.

Example 3

Inserts from example 1 were treated with a blasting pressure of 2.4 and 2.6 bar respectively. As a result most of the alumina layer on the rake face was removed.

The stress state in the second $TiC_{0.54}N_{0.46}$-layer was measured using X-ray diffraction. At the rake face the layer had compressive stress:

2.4 bar   -1840 MPa
2.6 bar   -2400 MPa

The stress state at the clearance face of the insert was tensile:

2.4 bar   +850 MPa
2.6 bar   +860 MPa

The exposed second $TiC_{0.54}N_{0.46}$-layer was intact apart from some small dots (< edge radius) at the very edge line. The example shows that high blasting pressure resulting in high compressive stresses can be applied without any major damages on the second $TiC_{0.54}N_{0.46}$-layer.

Example 4

Inserts from example 1 were treated by brushing of the edge line. The treatment resulted in a removal the top $TIC_xN_yO_z$ layer at the edge line as well as generating a smooth edge as disclosed in e.g. US 5,861,210.

Example 5

Inserts from example 2 were tested and compared with inserts from Sandvik commercial grade GC4044 in a short hole drilling operation. The tested inserts were mechanically clamped on the periphery of the drill head. In the centre, inserts from Sandvik commercial grade GC1044 were used. Tool life criteria: crater wear, plastic deformation, flank wear, or chipping >0.25 mm.

Material:   Low alloy steel SS2541-03, 285 HB.
Emulsion:   Blasocut BC25, 8%.
Operation:  Through hole, 45 mm.

|              | A         | B         | C         |
|--------------|-----------|-----------|-----------|
| Cutting speed: | 200 m/min | 180 m/min | 160 m/min |
| Feed:        | 0.12 mm/r | 0.13 mm/r | 0.15 mm/r |
| Drill:       | Diameter 15 mm, 3XD | | |
| Insert style: | CoroDrill 880-0202W05H-P, GR | | |

Results. A surprisingly significant difference in tool life, regarding plastic deformation and flank wear resistance, was seen. The inserts according to the invention showed a much improved flank wear resistance compared to the reference.

Drilled length at tool life:

|  | A | B | C |
|---|---|---|---|
| Inserts invention | 20 meters | >23 meters | 22 meters |
| Inserts reference | tool failure after | | |
| | 13 meters | 13 meters | 15 meters |

Example 6

Inserts from example 2 were tested and compared with inserts from Sandvik commercial grade 4044 in a short hole drilling operation. The tested inserts were mechanically clamped on the periphery of the drill head. In the center, inserts from Sandvik commercial grade 1044 were used. Tool life criteria: crater wear, plastic deformation, flank wear, or chipping >0.25 mm.

Material:    Low alloy steel SS2541-03, 285 HB.
Emulsion:    Blasocut BC25, 8%.
Operation:    Through hole, 48 mm.

|  | A | B |
|---|---|---|
| Cutting speed: | 170 m/min | 195 m/min |
| Feed: | 0.15 mm/r | 0.13 mm/r |
| Drill: | Diameter 18 mm, 3XD | |
| Insert style: | CoroDrill 880-0303W06H-P, GR | |

Results. A surprisingly significant difference in tool life, regarding plastic deformation and flank wear resistance, was seen. The inserts according to the invention showed a much improved flank wear resistance compared to the reference.
Drilled length at tool life:

|  | A | B |
|---|---|---|
| Inserts invention | >25 meters | 19 meters |
| Inserts reference | tool failure after | |
| | 14 meters | 13 meters |

Example 7

Inserts from example 2 were tested and compared with inserts from Sandvik commercial grade 4044 in a short hole drilling operation. The tested inserts were mechanically clamped on the periphery of the drill head. In the center, inserts from Sandvik commercial grade 1044 were used. Tool life criteria: crater wear, plastic deformation, flank wear, or chipping >0.25 mm.

Material:    Stainless steel SS2343, 160 HB.
Emulsion:    Blasocut BC25, 8%.
Operation:    Through hole, 40 mm.

|  | A | B | C |
|---|---|---|---|
| Cutting speed: | 240 m/min | 220 m/min | 200/m/min |
| Feed: | 0.10 mm/r | 0.10 mm/r | 0,11 mm/r |
| Drill: | Diameter 15 mm, 3XD | | |
| Insert style: | CoroDrill 880-0202W05H-P, LM | | |

Results. A surprisingly significant difference in tool life, regarding plastic deformation and flank wear resistance, was seen. The inserts according to the invention showed a much improved flank wear resistance compared to the inserts reference.

Drilled length at tool life:

|  | A | B | C |
| --- | --- | --- | --- |
| Inserts invention | 10 meters | >16 meters | >16 meters |
| Inserts reference | tool failure after | | |
| | 5 meters | 7 meters | 9 meters |

## Example 8

Inserts from example 2 were tested and compared with inserts from Sandvik commercial grades 4024 with respect to toughness in a short hole drilling operation. The tested inserts were mechanically clamped on the periphery of the drill head. In the center, inserts from Sandvik commercial grade 1044 were used. Tool life criteria: crater wear, plastic deformation, flank wear, or chipping >0.25 mm.

| | |
| --- | --- |
| Material: | Stainless steel SS2343, 160 HB. |
| Emulsion: | Blasocut BC25, 8%. |
| Operation: | Through hole, 50 mm. |
| Cutting speed: | 180 m/min |
| Feed: | 0.13 mm/r |
| Drill: | Diameter 18 mm, 3XD |
| Insert style: | CoroDrill 880-0303W06H-P, LM |

Results. An improvement in toughness behavior was seen. The inserts according to the invention showed a much improved toughness compared to the inserts reference.

Drilled length at tool life:

Inserts invention >20 meters
Inserts reference tool failure after 17 meters

## Example 9

Inserts from example 2 and example 4 were tested and compared with respect to toughness in a short hole drilling operation. The tested inserts were mechanically clamped on the periphery of the drill head. In the center, inserts from Sandvik commercial grade 1044 were used. Tool life criteria: crater wear, plastic deformation, flank wear, or chipping >0.25 mm.

| | |
| --- | --- |
| Material: | Low alloy steel SS2541-03, 285 HB. |
| Emulsion: | Blasocut BC25, 8%. |
| Operation: | Through hole, 45 mm. |
| Cutting speed: | 240 m/min |
| Feed: | 0.10 mm/r |
| Drill: | Diameter 15 mm, 3xD |
| Insert style: | CoroDrill 880-0202W05H-P, GR |

Results. A significant difference in toughness behavior was seen. The insert from example 2 got controlled flank wear whilst the insert from example 4 failed due to occurrence of a big crack penetrating half of the insert together with edge breakage adjacent to the crack.

Drilled length at tool life:

Inserts invention 20 meters
Inserts example 4 tool failure after 9 meters

**Claims**

1. Cemented carbide inserts comprising a substrate and a coating with excellent toughness properties particularly useful for toughness demanding short hole drilling in general steels

   **characterised in** the substrate comprising WC having an average grain size of 0.5-1.5 $\mu$m and 8-11 wt-% Co, preferably 9.5-10.5 wt-% Co, and 0.2-0.5 wt-% Cr whereby the cobalt binder phase has a CW-ratio of 0.80-0.90 and the coating comprising

   - a first, innermost layer of $TiC_xN_yO_z$ with x+y+z=1, preferably y>x and z<0.2, most preferably y>0.8 and z=0, with equiaxed grains of a size <0.5 $\mu$m and a total thickness <1.5 $\mu$m, preferably >0.1 $\mu$m,
   - a layer of $TiC_xN_yO_z$ with x+y+z=1, preferably with z=0, x>0.3 and y>0.3, most preferably x>0.5, with a thickness of 1-8 $\mu$m, preferably 2-7 $\mu$m, most preferably <6 $\mu$m, with columnar grains and with an average diameter of <5 $\mu$m, preferably 0.1-2 $\mu$m,
   - a layer of smooth, fine-grained, grain size about 0.5-2 $\mu$m $Al_2O_3$ consisting essentially of the K-phase with a thickness of 0.5-5 $\mu$m, preferably 0.5-2 $\mu$m, and
   - a further layer <1 $\mu$m thick, preferably 0.1-0.5 $\mu$m thick, of $TIC_xN_yO_z$ with x+y+z=1, preferably with y>x and z<0.3 whereby at the rake face the outermost $TiC_xN_yO_z$-layer and $Al_2O_3$-layer are fully or partly missing on 80% of the rake face surface area between the edge line and 100 $\mu$m inwards, in the direction perpendicular to the edge line.

2. Cemented carbide insert according to claim 1
   **characterised in that** the second $TiC_xNyO_z$ layer at the rake face has a compressive stress state of from 0 to 2500 MPa, preferably from 500 to 1500 MPa.

3. Method of making coated cemented carbide inserts with excellent toughness properties particularly useful for toughness demanding short hole drilling in general steels
   **characterised in** providing a cemented carbide substrate comprising WC having an average grain size of 0.5-1.5 $\mu$m, 8-11 wt-% Co, preferably 9.5-10.5 wt-% Co and 0.2-0.5 wt-% Cr by wetmilling powders with pressing agent, and small additions of carbon black or pure tungsten powder to obtain a CW-ratio in the sintered inserts of 0.80-0.90, in a slurry, drying the slurry to a powder, compacting and sintering and after conventional post sintering treatment depositing a coating comprising

   - a first, innermost layer of $TiC_xN_yO_z$ with x+y+z=1, preferably y>x and z<0.2, most preferably y>0.8 and z=0, with equiaxed grains with size <0.5 $\mu$m and a total thickness <1.5 $\mu$m, preferably >0.1 $\mu$m, using known CVD-methods,
   - a layer of $TIC_xN_yO_z$ with x+y+z=1, preferably with z=0, x>0.3 and y>0.3, most preferably x>0.5, with a thickness of 1-8 $\mu$m, preferably 2-7 $\mu$m, most preferably <6 $\mu$m, with columnar grains and with an average diameter of about <5 $\mu$m, preferably 0.1-2 $\mu$m, using preferably MTCVD-technique with acetonitrile as the carbon and nitrogen source for forming the layer in the temperature range of 700-900 °C,
   - a layer of smooth fine-grained grain size about 0.5-2 $\mu$m $Al_2O_3$ consisting essentially of the K-phase with a thickness of 0.5-5 $\mu$m, preferably 0.5-2 $\mu$m, using known CVD-methods,
   - a further layer <1 $\mu$m, preferably 0.1-0.5 $\mu$m thick, of $TIC_xN_yO_z$ with x+y+z=1, preferably with y>x and z<0.3, using known CVD-methods,
   - fully or partly removing the outermost $TiC_xN_yO_z$-layer and $Al_2O_3$-layer on at least 80 % of the rake face surface area between the edge line and 100 $\mu$m inwards in the direction perpendicular to the edge line by wet blasting the coated surface with fine-grained, 400-150 mesh, alumina powder.

Fig.1

Fig.2

Fig.3

**European Patent Office**

## EUROPEAN SEARCH REPORT

Application Number

EP 07 12 1947

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y,D | WO 2006/080888 A (SANDVIK INTELLECTUAL PROPERTY [SE]; AHLGREN MATS [SE]; AAGREN TORBJOER) 3 August 2006 (2006-08-03) * page 2, lines 4-18 * * page 2, line 38 - page 3, line 3 * * page 3, lines 30-32 * ----- | 1-3 | INV. C23C30/00 C22C29/08 B23B27/14 |
| Y | WO 01/16389 A (SANDVIK AB [SE]) 8 March 2001 (2001-03-08) * page 3, lines 19-25 * * page 4, line 22 - page 6, line 26 * * page 6, line 29 - page 7, line 11 * * page 8, lines 10-28 * * page 10, line 30 - page 11, line 13 * ----- | 1-3 | |
| Y | EP 1 038 989 A (SANDVIK AB [SE]) 27 September 2000 (2000-09-27) * page 3, paragraphs 10,13 * * page 5, paragraph 22 * ----- | 1-3 | |
| Y | EP 1 205 569 A (SANDVIK AB [SE]) 15 May 2002 (2002-05-15) * page 3, paragraphs 18,20,23 * * page 4, paragraphs 29,30 * * page 5, paragraphs 36,37 * * page 6, paragraphs 42,43 * ----- | 1-3 | TECHNICAL FIELDS SEARCHED (IPC) C23C C22C B23B |
| Y,D | EP 1 655 390 A (SANDVIK INTELLECTUAL PROPERTY [SE]) 10 May 2006 (2006-05-10) * column 3, paragraphs 13,14 * * column 3, paragraph 16 - column 4, paragraph 17 * ----- | 1-3 | |
| A | EP 1 563 933 A (SANDVIK INTELLECTUAL PROPERTY [SE]) 17 August 2005 (2005-08-17) * page 2, paragraph 10 * * page 3, paragraphs 11-13,15,16 * ----- -/-- | 1-3 | |

The present search report has been drawn up for all claims

| Place of search | Date of completion of the search | Examiner |
|---|---|---|
| Munich | 15 April 2008 | Joffreau, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

European Patent Office

**EUROPEAN SEARCH REPORT**

Application Number

EP 07 12 1947

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,P | EP 1 803 835 A (SANDVIK INTELLECTUAL PROPERTY [SE]) 4 July 2007 (2007-07-04) * page 2, paragraphs 9,12,14 * * page 3, paragraphs 15,17,18,21,22 * ----- | 1-3 | |
| A | EP 0 683 244 A (SUMITOMO ELECTRIC INDUSTRIES [JP]) 22 November 1995 (1995-11-22) ----- | | |

TECHNICAL FIELDS SEARCHED (IPC)

The present search report has been drawn up for all claims

| Place of search | Date of completion of the search | Examiner |
|---|---|---|
| Munich | 15 April 2008 | Joffreau, P |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 07 12 1947

This annex lists the patent family members relating to the patent documents cited in the above-mentioned European search report.
The members are as contained in the European Patent Office EDP file on
The European Patent Office is in no way liable for these particulars which are merely given for the purpose of information.

15-04-2008

| Patent document cited in search report | | Publication date | Patent family member(s) | | Publication date |
|---|---|---|---|---|---|
| WO 2006080888 | A | 03-08-2006 | BR | PI0605876 A | 18-12-2007 |
| | | | CN | 101018891 A | 15-08-2007 |
| | | | EP | 1846590 A1 | 24-10-2007 |
| | | | KR | 20070101201 A | 16-10-2007 |
| | | | SE | 528671 C2 | 16-01-2007 |
| | | | SE | 0500234 A | 01-08-2006 |
| | | | US | 2006286410 A1 | 21-12-2006 |
| WO 0116389 | A | 08-03-2001 | AT | 286152 T | 15-01-2005 |
| | | | DE | 60017161 D1 | 03-02-2005 |
| | | | DE | 60017161 T2 | 08-12-2005 |
| | | | EP | 1218558 A1 | 03-07-2002 |
| | | | IL | 147780 A | 25-07-2005 |
| | | | JP | 2003508632 T | 04-03-2003 |
| | | | US | 6406224 B1 | 18-06-2002 |
| EP 1038989 | A | 27-09-2000 | AT | 269429 T | 15-07-2004 |
| | | | DE | 60011494 D1 | 22-07-2004 |
| | | | DE | 60011494 T2 | 28-10-2004 |
| | | | JP | 2000308916 A | 07-11-2000 |
| | | | SE | 519005 C2 | 17-12-2002 |
| | | | SE | 9901149 A | 27-09-2000 |
| | | | US | 6250855 B1 | 26-06-2001 |
| EP 1205569 | A | 15-05-2002 | JP | 2002200516 A | 16-07-2002 |
| | | | SE | 519250 C2 | 04-02-2003 |
| | | | SE | 0004079 A | 09-05-2002 |
| | | | US | 2002081432 A1 | 27-06-2002 |
| EP 1655390 | A | 10-05-2006 | JP | 2006136998 A | 01-06-2006 |
| | | | US | 2006110532 A1 | 25-05-2006 |
| EP 1563933 | A | 17-08-2005 | AT | 343446 T | 15-11-2006 |
| | | | DE | 602005000191 T2 | 04-10-2007 |
| | | | JP | 2005231027 A | 02-09-2005 |
| | | | KR | 20060042066 A | 12-05-2006 |
| | | | SE | 527724 C2 | 23-05-2006 |
| | | | SE | 0400353 A | 18-08-2005 |
| | | | US | 2005181211 A1 | 18-08-2005 |
| EP 1803835 | A | 04-07-2007 | CN | 1990230 A | 04-07-2007 |
| | | | JP | 2007181915 A | 19-07-2007 |
| | | | KR | 20070072390 A | 04-07-2007 |
| | | | SE | 529857 C2 | 11-12-2007 |
| | | | SE | 0502959 A | 01-07-2007 |
| | | | US | 2007160844 A1 | 12-07-2007 |

EPO FORM P0459

For more details about this annex : see Official Journal of the European Patent Office, No. 12/82

**ANNEX TO THE EUROPEAN SEARCH REPORT
ON EUROPEAN PATENT APPLICATION NO.**

EP 07 12 1947

This annex lists the patent family members relating to the patent documents cited in the above-mentioned European search report.
The members are as contained in the European Patent Office EDP file on
The European Patent Office is in no way liable for these particulars which are merely given for the purpose of information.

15-04-2008

| Patent document cited in search report | | Publication date | Patent family member(s) | | Publication date |
|---|---|---|---|---|---|
| EP 0683244 | A | 22-11-1995 | DE | 69505591 D1 | 03-12-1998 |
| | | | DE | 69505591 T2 | 15-07-1999 |
| | | | US | 5597272 A | 28-01-1997 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2006080888 A
- WO 2006080889 A
- EP 1655390 A
- EP 523021 A
- US 5861210 A

### Non-patent literature cited in the description

- **I.C. NOYAN ; J.B. COHEN.** *Residual Stress Measurement by Diffraction and Interpretation,* 1987, 117-130